(19) Europäisches Patentamt
European Patent Office
Office européen des brevets

(11) EP 4 577 012 A1

(12) EUROPEAN PATENT APPLICATION
published in accordance with Art. 153(4) EPC

(43) Date of publication:
**25.06.2025 Bulletin 2025/26**

(21) Application number: **23854795.4**

(22) Date of filing: **01.08.2023**

(51) International Patent Classification (IPC):
***H10K 30/50*** *(2023.01)* ***C08L 83/04*** *(2006.01)*
***H10K 30/88*** *(2023.01)*

(52) Cooperative Patent Classification (CPC):
**C08L 83/04; H10K 30/50; H10K 30/88;**
Y02E 10/549

(86) International application number:
**PCT/JP2023/028087**

(87) International publication number:
**WO 2024/038760 (22.02.2024 Gazette 2024/08)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **16.08.2022 JP 2022129649**

(71) Applicant: **SHIN-ETSU CHEMICAL CO., LTD.,**
**Chiyoda-ku,**
**Tokyo 1000005 (JP)**

(72) Inventors:
- **OHWADA, Hiroto**
  **Annaka-shi, Gunma 379-0224 (JP)**
- **TOYOSHIMA, Takeharu**
  **Annaka-shi, Gunma 379-0224 (JP)**
- **OZAI, Toshiyuki**
  **Annaka-shi, Gunma 379-0224 (JP)**
- **YAGINUMA, Atsushi**
  **Annaka-shi, Gunma 379-0224 (JP)**

(74) Representative: **Ter Meer Steinmeister & Partner Patentanwälte mbB**
**Nymphenburger Straße 4**
**80335 München (DE)**

# (54) SOLAR CELL ELEMENT COATING COMPOSITION, AND SOLAR CELL MODULE AND PRODUCTION METHOD THEREFOR

(57) Provided is a solar cell element coating composition comprising
(A) an organopolysiloxane which is represented by the following average unit formula (1):

$$(R^1R^3{}_2SiO_{1/2})_2(Ar_2SiO_{2/2})_a(R^2{}_2SiO_{2/2})_b \qquad (1)$$

[where $R^1$ is an alkenyl group, $R^2$ is a monovalent saturated hydrocarbon group, $R^3$ is a monovalent saturated hydrocarbon group or an aryl group, Ar is an aryl group, a is an integer of 1-100, b is an integer of 0-1,000, and a/(a+b) is a number of 0.01 to 1.0)],
(B) an organic silicon compound which has a hydrogen atom bonded to at least two silicon atoms in one molecule, and
(C) a platinum group metal catalyst which is activated by light of a wavelength of 200-500 nm.
The solar cell element coating composition can be applied directly onto a solar cell element in an organic thin film solar cell, a perovskite solar cell, and the like.



Processed by Luminess, 75001 PARIS (FR)

## Description

### TECHNICAL FIELD

The present invention relates to a solar cell element coating composition and to a solar cell module and a method of production.

### BACKGROUND ART

In recent years, research and development has been carried out on flexible solar cells that prioritize cost reductions and aesthetics, solar cells having see-through properties, organic thin-film solar cells that are lightweight and have excellent handleability, and solar cells with perovskite compounds in the power-generating layer (called "perovskite solar cells") that are both low-cost and highly efficient.

Compared with crystalline-silicon solar cells, perovskite solar cells can be inexpensively manufactured and have a high energy conversion efficiency. A perovskite solar cell element can be obtained by arranging, as successive layers from the light-receiving side: a light-transmitting substrate or light-transmitting film, a transparent conductive film, an electron-transporting layer, a power-generating layer, a hole-transporting layer and a back electrode. In the so-called modularization step which encapsulates the above element, structures are being investigated wherein an encapsulating material is applied to the back side of the back electrode, sealing the backmost surface of the element with a substrate, film or the like. Various structures have been described in the art, including structures that use glass or the like as a light-transmitting substrate on the light-receiving side and as the substrate on the backmost surface, and flexible structures that use a light-transmitting film on the light-receiving side and a film on the backmost surface.

Separately, given that perovskite compounds are sensitive to water vapor and that solar cells are exposed outdoors for a long time to a harsh environment, there exists a desire for perovskite solar cell modules to shut out water vapor to a high degree.

Various art has been disclosed that provides such water vapor-sensitive electronic devices with, in advance of the encapsulating step, a layer that serves as a barrier against water vapor on the device. For example, Patent Document 1 discloses art relating to a three-layer barrier coat that includes silicon, oxygen and carbon. It forms a water-vapor barrier film having flexibility and mechanical strength by means of plasma chemical vapor deposition (CVD). However, plasma CVD forms the film under a vacuum in a CVD unit. Because this requires the device to be placed within a vacuum chamber and treatment to be carried out in a vacuum environment, increasing the size of the device is difficult. In addition, vacuum processes and processes open to the atmosphere are both involved, and so process complexity and cost increases are unavoidable.

Patent Document 2 discloses art which forms a $ZnO$-$SiO_2$-$Al_2O$ film by a direct-current (DC) sputtering process. DC sputtering also requires a vacuum environment and thus poses similar challenges in terms of process complexity.

### PRIOR ART DOCUMENTS

### PATENT DOCUMENTS

Patent Document 1: JP-A 2014-100806
Patent Document 2: JP-A 2013-147710

### SUMMARY OF INVENTION

### TECHNICAL PROBLEM

In light of these circumstances, the object of the invention is to provide a solar cell element coating composition which, in organic thin-film solar cells, perovskite solar cells and the like, can be coated directly onto a solar cell element and cured under atmospheric pressure to form a protective film having high water-vapor barrier properties.

### SOLUTION TO PROBLEM

The inventors have conducted intensive investigations aimed at achieving the above objects. As a result, they have discovered that the solar cell element coating composition described below can be coated directly onto a solar cell element and cures under atmospheric pressure, providing a protective film having high water-vapor barrier properties.

Accordingly, the invention provides:

1. A solar cell element coating composition which includes:

(A) an organopolysiloxane represented by the following average unit formula (1)

$$(R^1R^3_2SiO_{1/2})_2(Ar_2SiO_{2/2})_a(R^2_2SiO_{2/2})_b \qquad (1)$$

[wherein each $R^1$ is independently an alkenyl group, each $R^2$ is independently a substituted or unsubstituted monovalent saturated hydrocarbon group, each $R^3$ is independently a substituted or unsubstituted monovalent saturated hydrocarbon group or a substituted or unsubstituted aryl group, Ar is a substituted or unsubstituted aryl group, 'a' is an integer from 1 to 100, 'b' is an integer from 0 to 1,000, and a/(a+b) is a number from 0.01 to 1.0],
(B) an organosilicon compound having at least two silicon-bonded hydrogen atoms per molecule, and
(C) a platinum group metal catalyst that is activated by light having a wavelength of from 200 to 500 nm;

2. The solar cell element coating composition of 1 above, wherein component (B) is at least one selected from (i) to (iii) below:

(i) an organohydrogenpolysiloxane of the average compositional formula (2) below

$$R^4_cH_dSiO_{(4-c-d)/2} \qquad (2)$$

(wherein each $R^4$ is independently a substituted or unsubstituted monovalent hydrocarbon group of 1 to 12 carbon atoms other than an alkenyl group, and c and d are numbers satisfying the conditions $0.7 \leq c \leq 2.1$, $0.01 \leq d \leq 1$ and $0.8 \leq c+d \leq 2.7$),
(ii) the product of an addition reaction of vinyl norbornene and/or diallylbisphenol A with a cyclic organohydrogenpolysiloxane, and
(iii) a SiH group-containing silane compound;

3. The solar cell element coating composition of 1 or 2 above, wherein component (C) includes a ($n^5$-cyclopentadienyl) trialiphatic platinum compound or a bis(β-diketonato)platinum compound;
4. A solar cell module having a solar cell element and a water-vapor barrier layer consisting of a cured form of the solar cell element coating composition of any of 1 to 3 above;
5. The solar cell module of 4 above, wherein the solar cell element is an organic thin-film solar cell element or a perovskite solar cell element; and
6. A method for producing a solar cell module, which method includes the steps of contacting the solar cell element coating composition of any of 1 to 3 above, either directly or through at least one other layer, with a solar cell element, irradiating the composition with light having a wavelength of between 200 nm and 500 nm under atmospheric pressure, and subsequently curing the composition with applied heat.

## ADVANTAGEOUS EFFECTS OF INVENTION

The solar cell element coating composition of the invention can be applied directly onto a solar cell element and, when cured under atmospheric pressure, gives a cured product having high water-vapor barrier properties.
The solar cell element coating composition of the invention having such properties is useful as a protective film in organic thin-film solar cells and perovskite solar cells.

## BRIEF DESCRIPTION OF DRAWINGS

[FIG. 1] FIG. 1 is a schematic longitudinal sectional diagram showing an example of a perovskite solar cell module according to the invention.
[FIG. 2] FIG. 2 is a schematic longitudinal sectional diagram showing a perovskite solar cell fabricated in an Example of the invention.
[FIG. 3] FIG. 3 is a schematic longitudinal sectional diagram showing a perovskite solar cell module fabricated in an Example of the invention.

DESCRIPTION OF EMBODIMENTS

The invention is described more fully below.

[1] Coating Composition

(1) Component (A)

Component (A) in the solar cell element coating composition of the invention is an organopolysiloxane represented by the following average unit formula (1).

$$(R^1R^3{}_2SiO_{1/2})_2(Ar_2SiO_{2/2})_a(R^2{}_2SiO_{2/2})_b \qquad (1)$$

In the formula, each $R^1$ is independently an alkenyl group, each $R^2$ is independently a substituted or unsubstituted monovalent saturated hydrocarbon group, each $R^3$ is independently a substituted or unsubstituted monovalent saturated hydrocarbon group or a substituted or unsubstituted aryl group, and each Ar is independently a substituted or unsubstituted aryl group.

The alkenyl groups of $R^1$ are ones having preferably from 2 to 10 carbon atoms, and more preferably from 2 to 6 carbon atoms. Specific examples include vinyl, allyl, butenyl, pentenyl and hexenyl groups. Vinyl groups are especially preferred.

The monovalent saturated hydrocarbon groups of $R^2$ are ones having preferably from 1 to 12 carbon atoms, more preferably from 1 to 6 carbon atoms, and even more preferably from 1 to 3 carbon atoms. They may be linear, branched or cyclic. Specific examples include linear or branched alkyl groups such as methyl, ethyl, n-propyl, isopropyl, n-butyl, sec-butyl, tert-butyl, n-pentyl, n-hexyl and n-heptyl groups; and cycloalkyl groups such as the cyclohexyl group. Some or all hydrogen atoms on these groups may be substituted with halogen atoms such as chlorine, fluorine or bromine. Specific examples include halogenated alkyl groups such as chloromethyl, 3-chloropropyl and 3,3,3-trifluoropropyl groups.

Of these, from the standpoint of heat resistance, methyl groups are preferred.

The monovalent saturated hydrocarbon groups of $R^3$ are ones having preferably from 1 to 12 carbon atoms, more preferably from 1 to 6 carbon atoms, and even more preferably from 1 to 3 carbon atoms. They may be linear, branched or cyclic. Specific examples include the same groups as those mentioned for $R^2$.

The aryl groups of $R^3$ are ones having preferably from 6 to 20 carbon atoms, and more preferably from 6 to 10 carbon atoms. Specific examples include phenyl, naphthyl, tolyl, xylyl and mesityl groups. Some or all of the hydrogen atoms on these groups may be substituted with halogen atoms such as chlorine, fluorine or bromine. Examples include halogen-substituted aryl groups such as the chlorophenyl group.

Of these, methyl or phenyl groups are preferred.

The aryl groups of Ar are ones having preferably from 6 to 20 carbon atoms, and more preferably from 6 to 10 carbon atoms. Specific examples include the same groups as those mentioned for $R^3$. Phenyl groups are preferred.

Of all the silicon-bonded hydrocarbon groups ($R^1$, $R^2$, $R^3$ and Ar) in component (A), the methyl group content is preferably from 20 to 99 mol%, more preferably from 40 to 97 mol%, and even more preferably from 60 to 95 mol%. Within such a range, a cured product of excellent heat resistance can be obtained.

The subscript 'a' is an integer from 1 to 100, preferably an integer from 1 to 50, and more preferably an integer from 20 to 40. The subscript 'b' is an integer from 0 to 1,000, preferably an integer from 1 to 1,000, more preferably an integer from 1 to 500, and even more preferably an integer from 100 to 400. Also, a/(a+b) is a number from 0.01 to 1.0, preferably a number from 0.01 to 0.4, and more preferably a number from 0.05 to 0.3.

The molecular weight of component (A) is not particularly limited, although the standard polystyrene-equivalent weight-average molecular weight (Mw) measured by gel permeation chromatography (GPC) using tetrahydrofuran (THF) as the solvent is preferably from 500 to 100,000, more preferably from 700 to 50,000, and even more preferably from 1,000 to 30,000.

Specific examples of component (A) include, but are not limited to, those represented by the following formulas. In the formulas below and elsewhere in this Specification, "Me" stands for a methyl group, "Ph" stands for a phenyl group, and "Vi" stands for a vinyl group. Component (A) may be of one type used alone or two or more may be used in combination.

$$(ViMe_2SiO_{1/2})_2(Ph_2SiO_{2/2})_a(Me_2SiO_{2/2})_b$$

$$(ViMePhSiO_{1/2})_2(Ph_2SiO_{2/2})_a(Me_2SiO_{2/2})_b$$

$$(ViMe_2SiO_{1/2})_2(Ph_2SiO_{2/2})_a$$

$(ViMePhSiO_{1/2})_2(Ph_2SiO_{2/2})_a$

(In these formulas, 'a' and 'b' are as defined above.)

(2) Component (B)

Component (B) in the solar cell element coating composition of the invention is an organosilicon compound having at least two silicon-bonded hydrogen atoms on the molecule. The SiH groups in component (B) are added by hydrosilylation with addition-reactive carbon-carbon double bonds in component (A), giving a cured product having a three-dimensional network structure. Compounds (i) to (iii) below may be used as component (B).

(i) Organohydrogenpolysiloxanes of average compositional formula (2) below

$$R^4_cH_dSiO_{(4-c-d)/2} \qquad (2)$$

In the formula, each $R^4$ is independently a substituted or unsubstituted monovalent hydrocarbon group of 1 to 12, especially 1 to 6, carbon atoms other than an alkenyl group, and c and d are numbers which satisfy the conditions $0.7 \leq c \leq 2.1$, $0.01 \leq d \leq 1$ and $0.8 \leq c+d \leq 2.7$.

In the average compositional formula (2), the monovalent hydrocarbon group of 1 to 12 carbon atoms represented by $R^4$ may be linear, branched or cyclic. Specific examples include alkyl groups such as methyl, ethyl, n-propyl, isopropyl, n-butyl, tert-butyl, n-pentyl, isopentyl, n-hexyl and sec-hexyl groups; cycloalkyl groups such as cyclopentyl and cyclohexyl groups; aryl groups such as phenyl and o-, m- and p-tolyl groups; aralkyl groups such as benzyl and 2-phenylethyl groups; and groups in which one or more hydrogen atom bonded to a carbon atom on the foregoing groups is substituted with, for example, a halogen atom, cyano or an epoxy ring-containing group, examples of such groups including halogenated alkyl groups such as chloromethyl, 3-chloropropyl and 3,3,3-trifluoropropyl groups, and also the 2-cyanoethyl group and the 3-glycidoxypropyl group.

Of these, methyl groups or phenyl groups are especially preferred because of the ease of industrial production and the ready availability.

The subscript 'c' is a number that satisfies the condition $0.7 \leq c \leq 2.1$, and preferably $1 \leq c \leq 1.8$.

The subscript 'd' is a number that satisfies the condition $0.01 \leq d \leq 1$, preferably $0.02 \leq d \leq 1$, and more preferably $0.1 \leq d \leq 1$.

Also, c+d is a number that satisfies the condition $0.8 \leq c+d \leq 2.7$, preferably $1 \leq c+d \leq 2.4$, and more preferably $1.6 \leq c+d \leq 2.2$.

The kinematic viscosity of component (i) is not particularly limited, although the kinematic viscosity as measured with an Ostwald viscometer at 23°C is preferably from 0.1 to 100,000 $mm^2/s$, and more preferably from 0.5 to 500 $mm^2/s$.

Non-limiting examples of component (i) include those represented by the following formulas.

$(Me_3SiO_{1/2})_2(HMeSiO_{2/2})_{45}(Me_2SiO_{2/2})_{17}$

$(HMe_2SiO_{1/2})_2(HMeSiO_{2/2})_2(Ph_2SiO_{2/2})_2$

(ii) Addition Reaction Products of Vinyl Norbornene and/or Diallylbisphenol A with Cyclic Organohydrogenpolysiloxanes

Alternatively, an addition reaction product of structural formula (3) or structural formula (4) below obtained by subjecting vinyl norbornene or diallylbisphenol A and a cyclic organohydrogenpolysiloxane to a hydrosilylation reaction may be used as component (B).

[Chem. 1]

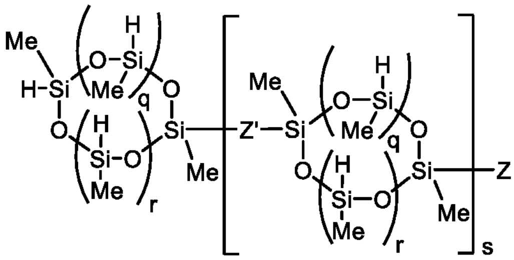 (3) 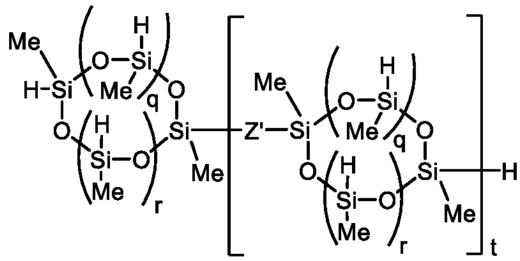 (4)

In the formulas, Z is a group of structural formula (5), (6) or (7) below or a group of structural formula (10) below; and Z' is a group of structural formula (8) or (9) below or a group of structural formula (11) below. The subscript 's' is an integer from 0 to 100, and preferably from 1 to 10; the subscript 't' is an integer from 1 to 100, and preferably from 1 to 20; and the subscripts 'q' and 'r' are each independently integers from 0 to 3, the sum of q and r at the respective cyclic siloxane sites being independently 2 or 3.

[Chem. 2]

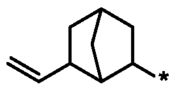 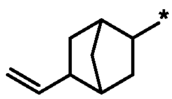 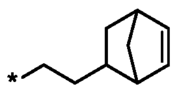

(5) (6) (7)

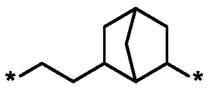 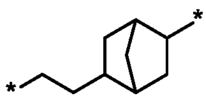

(8) (9)

(In formulas (5) to (9), an asterisk (*) denotes a bonding site with a silicon atom, and the configuration at each asymmetric carbon may be either cis (exo) or trans (endo).)

[Chem. 3]

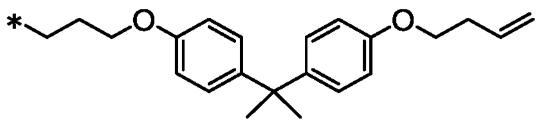 (10)

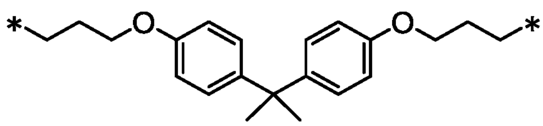 (11)

(In these formulas, an asterisk (*) denotes a bonding site with a silicon atom.)

Although the viscosity of component (ii) is not particularly limited, the viscosity as measured with a rotational viscometer at 25°C is preferably from 10 to 100,000 mPa·s, and more preferably from 100 to 10,000 mPa·s.

The compound of formula (3) or (4) may be obtained by subjecting 5-vinylbicyclo[2.2.1]hepta-2-ene of structural formula (12) below and/or diallylbisphenol A, and a cyclic siloxane of formula (13) below, to an addition reaction in the presence of a hydrosilylation reaction catalyst. A compound having a single structure, or a mixture of two or more isomers, may be used as the compound of structural formula (12) below.

[Chem. 4]

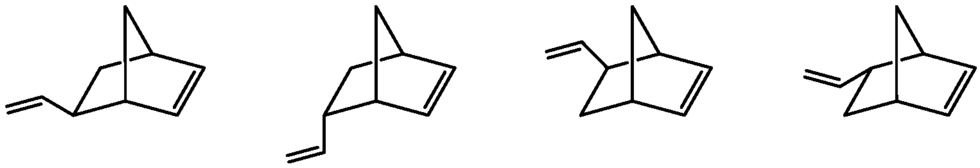

(12)

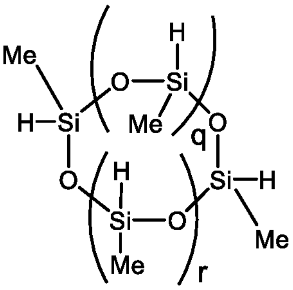

(13)

(In the formulas, q and r are as defined above.)

A known product may be used as the hydrosilylation catalyst. Illustrative examples include the following platinum group metal catalysts: platinum catalysts such as platinum metal on carbon powder, platinum black, platinic chloride, chloroplatinic acid, reaction products of chloroplatinic acid and monohydric alcohols, complexes of chloroplatinic acid and olefins, and platinum bis(acetoacetate); palladium catalysts; and rhodium catalysts. No particular limitations are imposed on, for example, the addition reaction conditions and the use of solvents; the addition reaction may be carried out under known conditions.

In the above reaction, diallylbisphenol A and the cyclic siloxane of above formula (13) are preferably used in amounts such that the number of moles of the cyclic siloxane of formula (13) is 1.05 times the number of moles of allyl groups included in the diallylbisphenol A, and 5-vinylbicyclo[2.2.1]hepta-2-ene is preferably used in an amount such that the number of moles of the cyclic siloxane of formula (13) is 1.05 times the number of moles of olefin included in the 5-vinylbicyclo[2.2.1]hepta-2-ene.

(iii) SiH Group-Containing Silane Compound

Aside from components (i) and (ii), the following silane compound may also be used as component (B).

[Chem. 5]

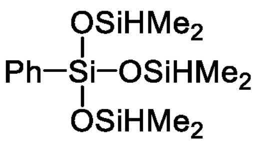

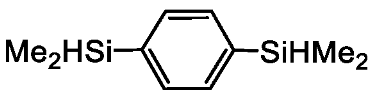

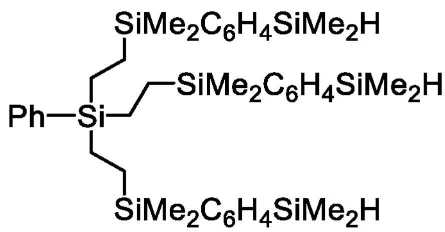

The kinematic viscosity of component (iii) is not particularly limited, although the kinematic viscosity as measured with an Ostwald viscometer at 23°C is preferably from 0.1 to 100,000 $mm^2/s$, and more preferably from 0.5 to 500 $mm^2/s$.

Component (B) of the invention may be of one type used alone or two or more may be used in combination.

The content of component (B) is not particularly limited, although the amount of silicon-bonded hydrogen atoms per mole of addition-reactive carbon-carbon double bonds in component (A) of the inventive composition is preferably from 0.5 to 2.0 moles, and more preferably from 0.8 to 1.5 moles.

(3) Component (C)

The platinum group metal catalyst for component (C) hydrosilylation, which is a catalyst for promoting hydrosilylation between addition-reactive carbon-carbon double bonds in component (A) and silicon-bonded hydrogen atoms in component (B), is inert when shielded from light and changes to an active platinum catalyst when irradiated with light having a wavelength of between 200 and 500 nm.

Specific examples of component (C) include ($\eta^5$-cyclopentadienyl) trialiphatic platinum compounds and derivatives thereof.

Of these, (cyclopentadienyl)trimethylplatinum complexes, (methylcyclopentadienyl)trimethylplatinum complexes, and derivatives in which these cyclopentadienyl groups have been modified are especially suitable.

Bis(β-diketonato)platinum compounds are also suitable examples of component (C). Of these, bis(acetylacetonato)platinum compounds and derivatives in which these acetylacetonato groups have been modified are especially suitable.

The amount of component (C) included in the composition is not particularly limited so long as it is an amount that promotes curing (hydrosilylation) of the composition, although the amount of platinum group metal atoms in this component, expressed in terms of weight units relative to the sum of the weights of components (A) and (B) in the composition, is preferably from 0.01 to 500 ppm, more preferably from 0.05 to 100 ppm, and even more preferably from 0.01 to 50 ppm.

Component (C) may be of one type used alone or two or more may be used in combination.

(4) Component (D)

A reaction regulator may be optionally added as component (D) to the solar cell element coating composition of the invention so as to keep thickening and gelation from arising prior to heat curing; i.e., during preparation of the composition or during its application onto a substrate.

Specific examples include 3-methyl-1-butyn-3-ol, 3-methyl-1-pentyn-3-ol, 3,5-dimethyl-1-hexyn-3-ol, 1-ethynylcyclohexanol, ethynylmethyldecylcarbinol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butynoxy)dimethylsilane, 1,3,5,7-tetramethyl-1,3,5,7-tetravinylcyclotetrasiloxane and 1,1,3,3-tetramethyl-1,3-divinyldisiloxane.

Of these, 1-ethynylcyclohexanol, ethynylmethyldecylcarbinol, 3-methyl-1-butyn-3-ol and bis(2,2-dimethyl-3-butynoxy)dimethylsilane are preferred.

When component (D) is included, the content thereof per 100 parts by weight of components (A) and (B) combined is preferably from 0.01 to 2.0 parts by weight, and more preferably from 0.01 to 0.1 part by weight. Within such a range, reaction regulating effects are fully exhibited.

(5) Other Ingredients

Aside from the above components (A) to (C) and the optionally used component (D), the solar cell element coating composition of the invention may also include the other ingredients mentioned below, insofar as doing so does not compromise the objects of the invention.

Examples of such ingredients include adhesion promoters having on the molecule one or more functional group selected from among alkenyl groups, (meth)acryl groups, carbonyl groups, epoxy groups, alkoxysilyl groups and amide groups; thixotropy regulators such as fumed silica; reinforcing agents such as crystalline silica; antioxidants such as hindered phenols and hindered amines; light stabilizers; heat resistance improvers such as metal oxides and metal hydroxides; colorants such as titanium oxide; thermal conductivity-imparting fillers such as alumina and crystalline silica; viscosity modifiers such as non-reactive silicone oils which have no reactive functional groups; conductivity-imparting agents such as silver, gold and other metal powders; and pigments and dyes for coloration.

Because the solar cell element coating composition of the invention readily yields a thin-film cured product of excellent light-transmitting properties, it is suitable as a transparent protective material in, for example, organic thin-film solar cell elements and perovskite solar cell elements. By using the solar cell element coating composition of the invention, it is possible to fabricate a cured product which has, at a thickness of 50 μm, for example, a total light transmittance as measured by a method in accordance with JIS K 7361-1: 1997 of 90% or more.

[2] Solar Cell Module

Next, an embodiment of the solar cell module according to the invention is described while referring to the diagrams. FIG. 1 shows an example of a perovskite solar cell module according to an embodiment of the invention.

A perovskite solar cell module 10 is composed of a light-receiving-side light-transmitting substrate or light-receiving-side light-transmitting film 1, a perovskite solar cell element 2 stacked on the reverse side thereof, a water-vapor barrier layer 3 formed on the back side thereof in such manner as to cover the solar cell element 2, an encapsulating material 4 formed on the back side thereof in such manner as to cover the water-vapor barrier layer 3, and a back-side

substrate or back-side film 5 stacked as the backmost surface portion on the encapsulating material 4.

Here, the light-receiving-side light-transmitting substrate or light-receiving-side light-transmitting film 1 is a transparent member serving as the side of the module where sunlight enters; a member having not only transparency, weather resistance and impact resistance, but also long-term reliability in outdoor usage is required. A specific example of this light-receiving-side light-transmitting substrate 1 is transparent glass; soda-lime glass or water white tempered glass is preferred. The light-receiving-side light-transmitting film 1 is exemplified by a resin film, the use of a light-transmitting film having high water-vapor barrier properties being preferred.

A perovskite solar cell element 2 generally has a structure in which an electron transporting layer, a power-generating layer formed of a perovskite compound, a hole transporting layer and a back electrode are arranged as successive layers on the light-receiving-side light-transmitting substrate or light-receiving-side light-transmitting film 1, although the structure is not limited to this.

The water-vapor barrier layer 3, by application of the inventive solar cell element coating composition onto the back side of the perovskite solar cell element 2, is disposed so as to uninterruptedly cover the solar cell element 2. It is desirable for the water-vapor barrier layer 3 to adhere well to the light-receiving-side light-transmitting substrate or light-receiving-side light-transmitting film 1 and to the perovskite solar cell element 2.

The encapsulating material 4 provided on the back side of the perovskite solar cell element 2 is preferably one which has flexibility and transparency and which enables durability to be achieved.

Water white glass, soda-lime glass or the like may be used as the back-side substrate 5.

Examples of the back-side film 5 include films in which water vapor transmission is controlled, such as laminated films combining a fluoroplastic film with a polyethylene terephthalate (PET) film, laminated films combining a metal thin-film with a PET film, and films composed of a thin metal layer vapor-deposited on a polyethylene naphthalate (PEN) film or the like.

In cases where the back-side substrate or back-side film 5 is light-transmitting, the resulting solar cell module is a see-through type, enabling the range of application to be expanded.

[3] Method for Producing Solar Cell Module

The solar cell element coating composition of the invention, by passing through a curing step in which it is brought into direct contact with a solar cell element and cured, is able to form a water-vapor barrier layer. The method of bringing the coating composition into contact with the solar cell element is not particularly limited and may involve, for example, a dispensing, casting, dipping, roll coating, spraying or screen printing process. The thickness of the water-vapor barrier layer is not particularly limited. For example, when the inventive composition is used in organic thin-film solar cells and perovskite solar cells, the thickness is preferably from 1 to 3,000 μm, more preferably from 10 to 1,000 μm, and even more preferably from 20 to 500 μm.

Where necessary, the solar cell element coating composition of the invention may be applied over one or more other layer, such as an inorganic layer of SiO, SiN, AlO or the like, formed on the solar cell element. In cases where a plurality of layers are stacked on the solar cell element, the cured form of the inventive solar cell element coating composition may also be used as buffer films between the layers. In addition, a method that involves, for example, laminating films obtained by curing the solar cell element coating composition of the invention may be used.

During curing of the solar cell element coating composition of the invention, activation of the platinum group metal catalyst is carried out by irradiating light having a wavelength of between 200 and 500 nm, preferably between 200 to 370 nm. A UV-LED lamp, metal halide lamp, mercury vapor lamp or the like may be used for light irradiation.

From the standpoint of the cure rate of the composition and to prevent discoloration, the irradiation intensity is preferably from 30 to 2,000 $mW/cm^2$ and the irradiation dose is preferably from 3,000 to 100,000 $mJ/cm^2$. The temperature at the time of irradiation is not particularly limited, so long as it is a temperature that does not adversely affect the solar cell element. The temperature is preferably between 10°C and 60°C, and more preferably between 20°C and 40°C.

Following such light irradiation, heating may be carried out within a range that does not adversely affect the solar cell element. The heating temperature is preferably between 50°C and 80°C, and more preferably between 50°C and 70°C. The heating time is preferably from 1 to 60 minutes, and more preferably from 10 to 30 minutes.

## EXAMPLES

Examples and Comparative Examples are given below by way of illustration, although the invention is not limited by these Examples. In the following Examples, "Me" stands for a methyl group, "Ph" for a phenyl group, and "Vi" for a vinyl group. The kinematic viscosities are measured values obtained with an Ostwald viscometer, and the viscosities are measured values obtained with a rotational viscometer.

[1] Preparation of Coating Compositions

[Examples 1-1 to 1-5, Comparative Examples 1-1 to 1-3]

Solar cell element coating compositions were prepared by mixing together components (A) to (D) below in the amounts (parts by weight) shown in Table 1.

Component (A)

(A-1) An organopolysiloxane of average unit formula (14) below (Mw, 28,000)

$$(ViMe_2SiO_{1/2})_2(Me_2SiO_{2/2})_{300}(Ph_2SiO_{2/2})_{30} \quad (14)$$

(A-2) An organopolysiloxane of average unit formula (15) below (Mw, 11,200)

$$(ViMe_2SiO_{1/2})_2(Me_2SiO_{2/2})_{68}(Ph_2SiO_{2/2})_{30} \quad (15)$$

(A-3) An organopolysiloxane of average unit formula (16) below (Mw, 905)

$$(ViMePhSiO_{1/2})_2(Ph_2SiO_{2/2})_3 \quad (16)$$

Component (B)

(B-1) A compound of average unit formula (17) below (kinematic viscosity at 23°C, 45 $mm^2/s$; silicon-bonded hydrogen atom content, 0.0112 mol/g)

$$(Me_3SiO_{1/2})_2(HMeSiO_{2/2})_{45}(Me_2SiO_{2/2})_{17} \quad (17)$$

(B-2) A compound of average unit formula (18) below (kinematic viscosity at 23°C, 21 $mm^2/s$; silicon-bonded hydrogen atom content, 0.0061 mol/g)

$$(HMe_2SiO_{1/2})_2(HMeSiO_{2/2})_2(Ph_2SiO_{2/2})_2 \quad (18)$$

(B-3) A siloxane compound of structural formula (19) below (kinematic viscosity at 25°C, 1,000 mPa·s; silicon-bonded hydrogen atom content, 0.0066 mol/g)

[Chem. 6]

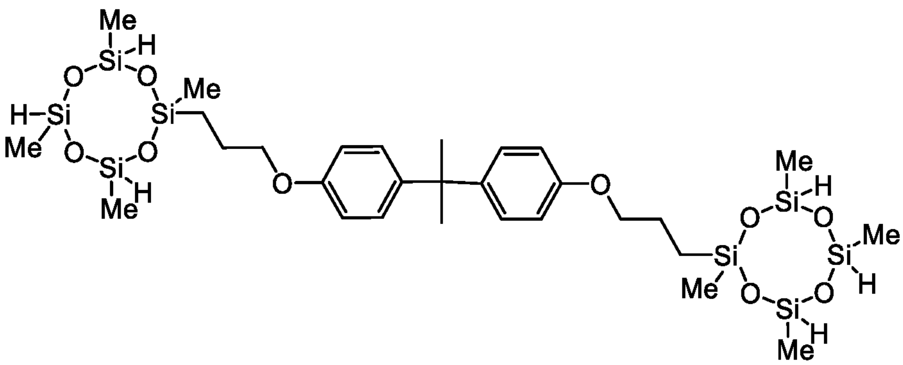

(19)

(B-4) A compound of structural formula (20) below (kinematic viscosity at 23°C, 1.8 $mm^2/s$; silicon-bonded hydrogen atom content, 0.0092 mol/g)

[Chem. 7]

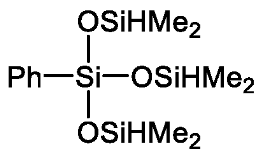

(20)

Component (C)

(C-1) Toluene solution of methylcyclopentadienyltrimethyl platinum complex (platinum concentration, 0.5 wt%)

(C'-2) Toluene solution of platinum 1,3-divinyl-1,1,3,3-tetramethyldisiloxane complex (platinum concentration, 0.5 wt%)

Component (D)

(D-1) 1.0 wt% Toluene solution of bis(2,2-dimethyl-3-butynoxy)dimethylsilane

(D-2) Bis(2,2-dimethyl-3-butynoxy)dimethylsilane

[Table 1]

| | | Example 1-1 | Example 1-2 | Example 1-3 | Example 1-4 | Example 1-5 | Comp. Example 1-1 | Comp. Example 1-2 | Comp. Example 1-3 |
|---|---|---|---|---|---|---|---|---|---|
| Formulation (pbw) | (A-1) | 100 | | | | | 100 | | |
| | (A-2) | | 100 | 100 | | | | 100 | |
| | (A-3) | | | | 100 | 100 | | | 100 |
| | (B-1) | 1 | | | | | 1 | | |
| | (B-2) | | 3.4 | | 40 | | | 3.4 | 40 |
| | (B-3) | | | 3 | | | | | |
| | (B-4) | | | | | 25 | | | |
| | (C-1) | 0.6 | 0.6 | 0.6 | 0.6 | 0.6 | | | |
| | (C'-2) | | | | | | 0.6 | 0.6 | 0.6 |
| | (D-1) | 0.1 | 0.1 | 0.1 | 0.1 | 0.1 | | | |
| | (D-2) | | | | | | 0.1 | 0.1 | 0.1 |
| SiH groups/addition-reactive carbon-carbon double bonds | | 1.1 | 1.1 | 1.1 | 1.2 | 1.1 | 1.1 | 1.1 | 1.2 |

[2] Production of Solar Cell Modules

[Examples 2-1 to 2-5, Comparative Examples 2-1 to 2-3]

Using the solar cell element coating compositions obtained in Examples 1-1 to 1-5 and Comparative Examples

1-1 to 1-3, solar cell modules were produced in the following manner.

As shown in FIG. 2, a perovskite solar cell element 2 (size, 25×25 mm) having a transparent conductive film, an electron transporting layer, a perovskite layer and a hole transporting layer arranged as successive layers and having a positive electrode formed on the hole transporting layer was stacked on, as a light-receiving-side light-transmitting substrate 1, a glass substrate (size, 50×50 mm; thickness, 3.2 mm) so as to be positioned at the center of the light-receiving-side light-transmitting substrate 1, giving a sample perovskite solar cell 11.

Next, as shown in FIG. 3, a fluoropolymer pressure-sensitive tape (thickness, 0.25 mm; 3 mm wide × 3 mm; from Chukyo Chemical Industries, Ltd.) was provided as a dam material 6 on the outer periphery of the light-receiving-side light-transmitting substrate 1. The solar cell element coating composition was subsequently applied to a thickness of 0.1 mm onto the perovskite solar cell element 2.

In Examples 1-1 to 1-5, after applying the solar cell element coating composition onto the perovskite solar cell element 2, the composition was irradiated from above with ultraviolet light at 25°C using a metal halide lamp (HANDY UV-100, from ORC Manufacturing Co., Ltd.) at a UV intensity of 100 $mW/cm^2$ and to a cumulative dose of 3,000 $mJ/cm^2$. This was followed by 1 hour of heating at 60°C, curing the solar cell element coating composition and thus giving a water-vapor barrier layer 3.

Next, a glass substrate (size, 50×50 mm; thickness, 3.2 mm) as the back-side substrate 5 was placed on top of the dam material 6, and the back surface was secured with polyimide tape 7 so as to hold the back-side substrate 5 in place, giving a sample perovskite solar cell module 12.

In Comparative Examples 1-1 to 1-3, the solar cell element coating composition was applied on top of the perovskite solar cell element 2 and subsequently heated for 1 hour at 100°C, thereby curing the solar cell element coating composition.

Next, a glass substrate (size, 50×50 mm; thickness, 3.2 mm) as the back-side substrate 5 was placed on top of the dam material 6, and the back surface was secured with polyimide tape 7 so as to hold the back-side substrate 5 in place, giving a sample perovskite solar cell module 12.

[Initial Output Retention]

In the resulting sample perovskite solar cells, light was irradiated from the direction of the light-transmitting substrate 1 surface using a simulated sunlight irradiation device, and the output ($W_1$) of the sample perovskite solar cell module 12 was measured.

The initial output retention (%) was computed from the output ($W_1$) of the sample perovskite solar cell module 12 and the output ($W_c$) of the sample perovskite solar cell 11 prior to modularization. Cases in which the initial output retention was 95% or more were rated as "○"; cases in which it was less than 95% were rated as "×." The results are shown in Table 2.

$$\text{Initial output retention (\%)} = (W_1/W_c) \times 100$$

[Output Retention after Moisture Resistance Test]

In addition, the output ($W_2$) of the sample perovskite solar cell module 12 following 500 hours of exposure in a 60°C, 90% RH environment was measured by the same method as described above and the output retention (%) after a moisture-resistance test was computed. Cases in which the output retention following a moisture resistance test was 80% or more were rated as "○"; cases in which it was less than 80% were rated as "×." The results are shown in Table 2.

$$\text{Output retention after moisture resistance test (\%)} = (W_2/W_c) \times 100$$

[Table 2]

| | Example 2-1 | Example 2-2 | Example 2-3 | Example 2-4 | Example 2-5 | Comp. Example 2-1 | Comp. Example 2-2 | Comp. Example 2-3 |
|---|---|---|---|---|---|---|---|---|
| Solar cell element coating composition | Example 1-1 | Example 1-2 | Example 1-3 | Example 1-4 | Example 1-5 | Comp. Example 1-1 | Comp. Example 1-2 | Comp. Example 1-3 |

(continued)

| | Example 2-1 | Example 2-2 | Example 2-3 | Example 2-4 | Example 2-5 | Comp. Example 2-1 | Comp. Example 2-2 | Comp. Example 2-3 |
|---|---|---|---|---|---|---|---|---|
| Initial output retention | ○ | ○ | ○ | ○ | ○ | × | × | × |
| Output retention after moisture resistance test (after 500 hours at 60°C/90%RH) | ○ | ○ | ○ | ○ | ○ | - | - | - |

As shown in Table 2, perovskite solar cells having a water-vapor barrier layer made of the cured form of the solar cell element coating compositions of Examples 1-1 to 1-5 exhibit good output retentions even when exposed for 500 hours to a 60°C, 90% RH environment.

On the other hand, because perovskite solar cells in which the compositions of Comparative Examples 1-1 to 1-3 were used had low initial output retentions, moisture-resistance tests could not be carried out. This is likely because, due to heating to 100°C during formation of the water-vapor barrier layer, damage arose in the heat-sensitive perovskite solar cell elements, resulting in a decreased output.

REFERENCE SIGNS LIST

1 Light-receiving-side light-transmitting substrate/Light-receiving-side light-transmitting film

2 Perovskite solar cell element

3 Water-vapor barrier layer

4 Encapsulating material

5 Back-side substrate/Back-side film

6 Dam material

7 Polyimide tape

10 Perovskite solar cell module

11 Sample perovskite solar cell

12 Sample perovskite solar cell module

**Claims**

**1.** A solar cell element coating composition comprising:

(A) an organopolysiloxane represented by the following average unit formula (1)

$$(R^1R^3{}_2SiO_{1/2})_2(Ar_2SiO_{2/2})_a(R^2{}_2SiO_{2/2})_b \quad (1)$$

[wherein each $R^1$ is independently an alkenyl group, each $R^2$ is independently a substituted or unsubstituted monovalent saturated hydrocarbon group, each $R^3$ is independently a substituted or unsubstituted monovalent

saturated hydrocarbon group or a substituted or unsubstituted aryl group, Ar is a substituted or unsubstituted aryl group, 'a' is an integer from 1 to 100, 'b' is an integer from 0 to 1,000, and a/(a+b) is a number from 0.01 to 1.0],
(B) an organosilicon compound having at least two silicon-bonded hydrogen atoms per molecule, and
(C) a platinum group metal catalyst that is activated by light having a wavelength of from 200 to 500 nm.

**2.** The solar cell element coating composition of claim 1, wherein component (B) is at least one selected from (i) to (iii) below:

(i) an organohydrogenpolysiloxane of the average compositional formula (2) below

$$R^4_cH_dSiO_{(4-c-d)/2} \qquad (2)$$

(wherein each $R^4$ is independently a substituted or unsubstituted monovalent hydrocarbon group of 1 to 12 carbon atoms other than an alkenyl group, and c and d are numbers satisfying the conditions $0.7 \leq c \leq 2.1$, $0.01 \leq d \leq 1$ and $0.8 \leq c+d \leq 2.7$),
(ii) the product of an addition reaction of vinyl norbornene and/or diallylbisphenol A with a cyclic organohydrogenpolysiloxane, and
(iii) a SiH group-containing silane compound.

**3.** The solar cell element coating composition of claim 1 or 2, wherein component (C) includes a ($n^5$-cyclopentadienyl) trialiphatic platinum compound or a bis(β-diketonato)platinum compound.

**4.** A solar cell module comprising a solar cell element and a water-vapor barrier layer consisting of a cured form of the solar cell element coating composition of any one of claims 1 to 3.

**5.** The solar cell module of claim 4, wherein the solar cell element is an organic thin-film solar cell element or a perovskite solar cell element.

**6.** A method for producing a solar cell module, comprising the steps of contacting the solar cell element coating composition of any one of claims 1 to 3, either directly or through at least one other layer, with a solar cell element, irradiating the composition with light having a wavelength of between 200 nm and 500 nm under atmospheric pressure, and subsequently curing the composition with applied heat.

FIG.1

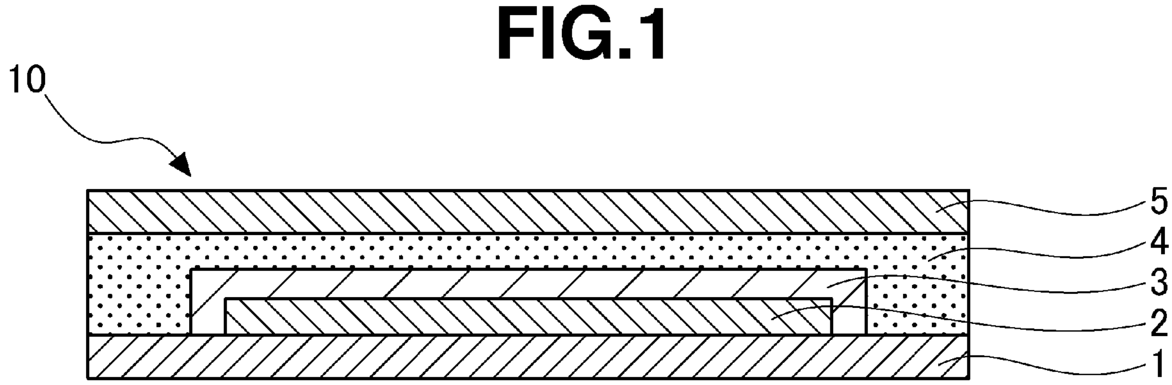


FIG.2

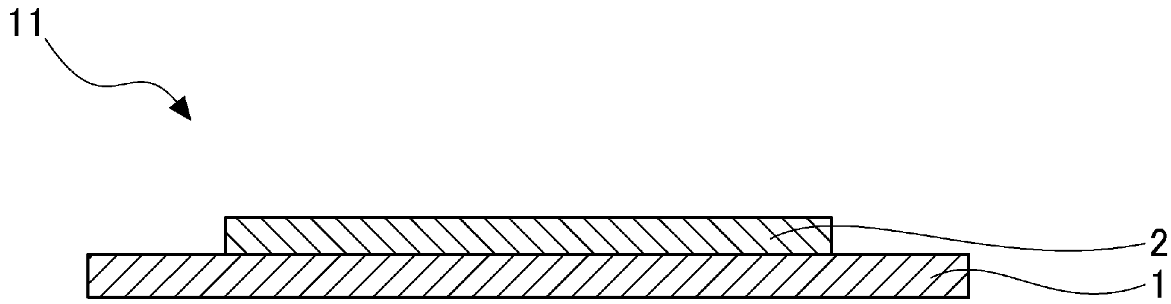


FIG.3

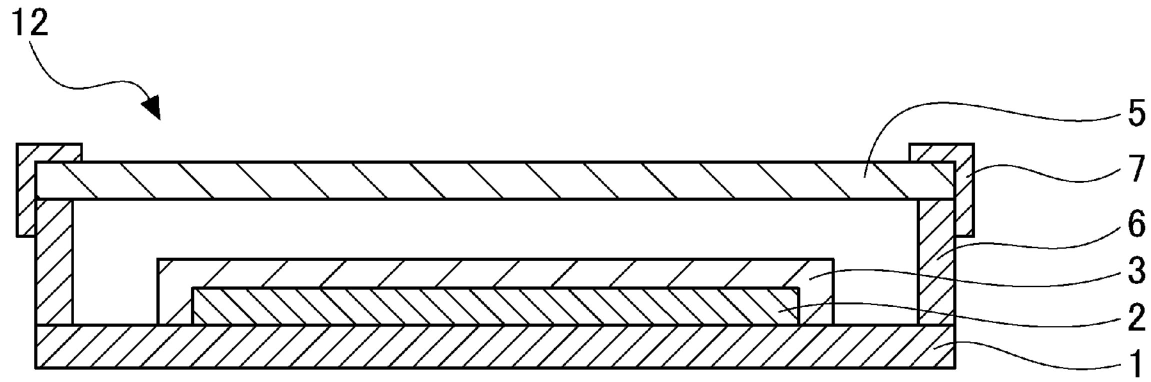

## INTERNATIONAL SEARCH REPORT

International application No. **PCT/JP2023/028087**

**A. CLASSIFICATION OF SUBJECT MATTER**

***H10K 30/50***(2023.01)i; ***C08L 83/04***(2006.01)i; ***H10K 30/88***(2023.01)i
FI: H10K30/50; C08L83/04; H10K30/88

According to International Patent Classification (IPC) or to both national classification and IPC

**B. FIELDS SEARCHED**

Minimum documentation searched (classification system followed by classification symbols)

H01L31/00-31/20; H10K30/00-99/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2013-518406 A (LG CHEM, LTD.) 20 May 2013 (2013-05-20)<br>paragraphs [0002]-[0105] | 1-6 |
| Y | JP 2013-521640 A (MOMENTIVE PERFORMANCE MATERIALS GMBH) 10 June 2013 (2013-06-10)<br>paragraphs [0011]-[0162] | 1-6 |
| Y | JP 2014-82399 A (SHIN ETSU CHEM CO LTD) 08 May 2014 (2014-05-08)<br>paragraphs [0028]-[0074] | 1-6 |
| A | JP 2009-534840 A (DOW CORNING CORPORATION) 24 September 2009 (2009-09-24) | 1-6 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 October 2023** | **17 October 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/028087**

| Patent document cited in search report | Publication date (day/month/year) | Patent family member(s) | Publication date (day/month/year) |
|---|---|---|---|
| JP 2013-518406 A | 20 May 2013 | US 2013/0014823 A1<br>paragraphs [0003]-[0084]<br>WO 2011/090366 A2<br>EP 2530741 A2<br>KR 10-2011-0087241 A<br>CN 102812562 A | |
| JP 2013-521640 A | 10 June 2013 | US 2013/0059109 A1<br>paragraphs [0009]-[0257]<br>WO 2011/107592 A1<br>CN 102892837 A | |
| JP 2014-82399 A | 08 May 2014 | (Family: none) | |
| JP 2009-534840 A | 24 September 2009 | US 2009/0090413 A1<br>WO 2007/120905 A2<br>EP 2333841 A2<br>KR 10-2008-0112381 A<br>CN 101467263 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014100806 A
- JP 2013147710 A